# EUROPÄISCHE PATENTSCHRIFT

(11) **EP 1 665 371 B1**
(45) Veröffentlichungstag und Bekanntmachung des Hinweises auf die Patenterteilung: **07.03.2007**
(21) Anmeldenummer: 04762735.1
(22) Anmeldetag: 03.09.2004
(51) Int. Cl.: H01L 21/768, H01L 23/532

(54) **VERFAHREN ZUR HERSTELLUNG EINER MULTIFUNKTIONELLEN DIELEKTRIKUMSSCHICHT AUF EINEM SUBSTRAT**
METHOD FOR PRODUCING A MULTIFUNCTIONAL DIELECTRIC LAYER ON A SUBSTRATE
PROCEDE POUR REALISER UNE COUCHE DIELECTRIQUE MULTIFONCTIONNELLE SUR UN SUBSTRAT

(30) Priorität: 25.09.2003 DE 10344389
(43) Veröffentlichungstag der Anmeldung: 07.06.2006
(73) Patentinhaber: Infineon Technologies AG, 81669 München (DE)
(72) Erfinder: HELNEDER, Johann, 85652 Landsham (DE); SCHWERD, Markus, 83607 Holzkirchen (DE); GOEBEL, Thomas, 81375 Muenchen (DE); MITCHELL, Andrea, 81667 Muenchen (DE); KOERNER, Heinrich, 83052 Bruckmuehl (DE); HOMMEL, Martina, 81739 Muenchen (DE)
(74) Vertreter: Lippert, Stachow & Partner
(86) Internationale Anmeldenummer: PCT/DE2004/001948
(87) Internationale Veröffentlichungsnummer: WO 2005/031854

(56) Entgegenhaltungen:
- US-A- 3 663 279
- US-A- 4 458 295
- US-A- 5 453 642
- US-A- 5 783 483
- US-A1- 2002 086 522
- US-A1- 2003 088 978

## Beschreibung

Die Erfindung betrifft ein Verfahren zur Herstellung einer multifunktionellen Dielektrikumsschicht auf frei liegenden metallischen Leitbahnsystemen auf einem Substrat, wobei auf den frei liegenden Metallleitbahnen ganzflächig eine weitere Metallschicht abgeschieden wird, die anschließend teilweise in ein nicht leitendes Metalloxid, die Dielektrikumsschicht, umgewandelt wird und wobei Teile der weiteren Metallschicht vor der Oxidation zur Bildung eines Metall-Dünnfilmwiderstandes abgedeckt werden.

Bei den bisher bekannt gewordenen Halbleiterbausteinen, basierend auf Si-Substraten, übernehmen vorzugsweise Kupferleitbahnen die elektrische Kontaktierung der einzelnen Funktionsschichten bzw. Funktionselemente einer Ebene und auch der Ebenen untereinander. Als besonderes Problem hat sich bei der Verwendung von Kupferleitbahnen erwiesen, dass Cu-Atome in das umliegende Dielektrikum diffundieren können und somit die elektrischen Eigenschaften des Halbleiterbausteines bis zur Funktionsunfähigkeit verändern können.

Als Substrate können selbstverständlich außer Si-Substraten auch andere Substrate, wie Glas, GaAs, InP, Leiterplatten, printed wiring Boards usw. in Betracht kommen.

Zur Verhinderung der Diffusion von Cu-Atomen in das Dielektrikum werden üblicher Weise Diffusionsbarrieren verwendet, die an den Seitenwänden der Cu-Leitbahnen eingebracht sind, also zwischen der Cu-Leitbahn und dem umgebenden Dielektrikum (SiO2) eingebracht sind und z.B. aus Ta(N) bestehen. Unter der im Folgenden verwendeten Bezeichnung Ta(N) soll hier eine Verbindung mit beliebiger Stöchiometrie aus Tantal und beliebigem Anteil Stickstoff verstanden werden. Damit wird ein ausreichender Diffusionsschutz gewährleistet. Da aber nach der Strukturierung der Kupferleitbahnen mittels der üblichen CMP-Prozessierung (Chemisch mechanisches Polieren) die Kupferschicht oben frei gelegt wird, muss diese Kupferschicht passiviert werden, um jegliche Oxidation zu verhindern. Erreicht wird dies dadurch, dass die freiliegende Leitbahnoberfläche (Cu-Schicht) mit einer geeigneten Dielektrikumsschicht, z.B. SiN-PECVD-Schicht versehen wird.

Nachteilig an diesem Interface ist allerdings der Schwachpunkt in Bezug auf Elektro- und Stressmigration, sowie die nicht optimale Haftung. Um hier eine Verbesserung zu erreichen, wurde z.B. eine selektive Abscheidung von Cobalt auf den frei liegenden Metallflächen mittels stromloser Elektrolyseverfahren versucht, was allerdings bisher nicht den gewünschten Erfolg gebracht hat.

Aus der US 4458295 geht ein Verfahren zur Herstellung einer Dielektrikumsschicht auf frei liegenden Metallleitbahnen, wobei eine weitere Metallschicht auf die Leiterbahnen aufgetragen wird, die anschließend in ein nicht leitendes Metalloxid umgewandelt wird. Dabei werden Teile der Metallschicht zur Bildung eines Dünnfilmwiderstandes abgedeckt und weiterhin die Metalloxidschicht auf einigen Leiterbahnen als MIM-Dielektrikum ausgebildet.

Weiterhin offenbart die US 5783483 die Herstellung von nicht leitenden Metalloxidschichten auf frei liegenden Leiterbahnen, wobei die Oxidschichten hier als Barriere- oder Passivierungsschicht verwendet werden.

Der Erfindung liegt nunmehr die Aufgabe zugrunde, ein einfach zu realisierendes Verfahren zur Herstellung einer multifunktionalen Passivierungsschicht für Kupferleitbahnen mit verbesserter Elektro- und Stressmigration sowie verbesserter Haftung der aufgebrachten dielektrischen Schicht zu schaffen.

Die der Erfindung zugrunde liegende Aufgabe wird durch das Verfahren gemäß Anspruch 1 dadurch gelöst, dass die Dielektrikumsschicht auf einigen Metallleitbahnen als Passivierungsschicht und auf anderen Metallleitbahnen als MIM-Dielektrikum zur Integration eines MIM-Kondensators ausgebildet ist.

Auf diese Weise kann eine bedeutend bessere Haftung der dielektrischen Schicht auf der Metallleitbahn, insbesondere auf der Cu-Schicht sowie eine verbesserte Elektro- und Stressmigration erreicht werden.

In einer ersten Ausgestaltung der Erfindung sind die Metallleitbahnen in einem Isolator auf einem Substrat eingebettet und an den Seitenwänden mit einer Diffusionsbarriere versehen worden. Die weitere Metallschicht wurde nach dem chemisch-mechanischen Polieren (CMP) auf die frei liegende Metallleitbahn, die aus Kupfer bestehen kann, aufgetragen.

Die Metallleitbahnen können aus Kupfer, Aluminium, Wolfram, Gold oder anderen leitfähigen Materialien bestehen.

In einer zweiten Ausgestaltung der Erfindung weisen die Metallleitbahnen eine subtraktive Architektur auf; indem eine auf einem Isolator auf dem Substrat ganzflächig abgeschiedene Metallschicht, z.B. durch RIE (reaktives Ionenätzen) bzw. ein Lift-Off-Verfahren o. dgl., nachträglich strukturiert worden ist und die weitere Metallschicht auf diesen abgeschieden wird. Die Metallleitbahnen bestehen hier z.B. aus Aluminium, Kupfer, Wolfram, Siliziden, Nitriden oder anderen leitfähigen Materialien.

Eine dritte Ausgestaltung der Erfindung ist dadurch gekennzeichnet, dass auf Metallleitbahnen, die durch "Pattern Plating" (d.h. elektrolytisches Abscheiden von Metall in eine Lackmaske und anschließendes Entfernen der Lackmaske) auf einem Isolator auf dem Substrat hergestellt worden sind, die weitere Metallschicht aufgetragen wird.

Die Umwandlung der weiteren Metallschicht in ein nichtleitendes Metalloxid erfolgt zweckmäßigerweise durch eine anodische, thermische oder plasmachemische Oxidation in einem backendverträglichen Temperaturbereich zwischen 20 - 500 °C.

In einer besonderen Ausgestaltung der Erfindung erfolgt die Herstellung der weiteren Metallschicht durch einen PVD-Abscheideprozess.

Vorzugsweise wird Tantal oder Tantalnitrid abgeschieden.

Gemäß einer weiteren Ausgestaltung der Erfindung wird eine Schichtfolge von Ta(N)/Ta oder Ta/Ta(N) abgeschieden. Weitere Materialien und -kombinationen, wie Ti, A1, Ti/Al, Zr, Hf, Nb, Ru, Rh, Ir, sind möglich.

Schließlich ist vorgesehen, dass bei der Oxidation Bereiche der weiteren Metallschicht ausgespart werden.

Die Abdeckung erfolgt bevorzugt mit einer SiO₂- oder Si₃N₄-Schicht.

Die Erfindung soll nachfolgend an einem Ausführungsbeispiel unter Verwendung von Ta(N) näher erläutert werden. In den zugehörigen Zeichnungen zeigen:
- Fig. 1:: eine auf einem Substrat befindliche Cu-Ebene nach dem CMP und eine darauf abgeschiedene PVD-Ta(N)-Schicht als weitere Metallschicht;
- Fig. 2:: das Substrat nach Fig. 1 nach der Abscheidung einer begrenzten SiO2-Schicht auf der Ta(N)-Schicht;
- Fig. 3:: das Substrat nach der Oxidation der freien Ta(N)-Schicht zu Tantalpentoxid, wobei die mit SiO2 abgedeckte Schicht der Ta(N)-Schicht unverändert bleibt und später einen Ta(N)-Widerstand ausbildet;
- Fig. 4:: das Substrat nach der Abscheidung einer weiteren Metallschicht und deren Strukturierung zur Ausbildung der oberen Elektrode eines MIM-Kondensators neben einem Ta(N)-Widerstand, der zuvor erzeugt wurde;
- Fig. 5:: das Substrat nach der Abscheidung einer weiteren SiO2-Schicht, die als Intermetalldielektrikum dient; und
- Fig. 6:: das Substrat nach Prozessierung einer weiteren Leitbahnebene und von Durchkontaktierungen zwischen den beiden Levels.

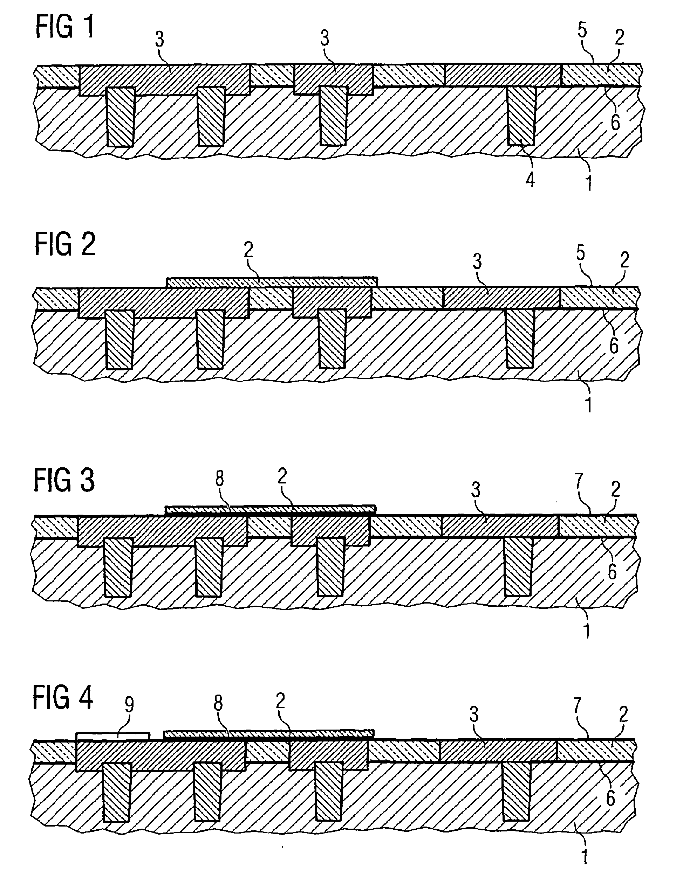

Fig. 1 zeigt ein Substrat 1, z.B. aus Silizium, mit einer Cu-Metallisierung 3, die in einer SiO2-Schicht 2 eingebettet ist (Damascene) und über Durchkontaktierungen 4 aus Cu, oder einem anderen Metall, wie Wolfram, mit einem tieferen Cu-Level elektrisch verbunden ist. Die frei liegende Cu-Metallisierung 3 ist nach einem CMP-Prozess (chemischmechisches Polieren) durch einen PVD-Abscheideprozess mit einer weiteren Metallschicht 5, z.B. Ta(N)-Schicht, abgedeckt worden. Die Haftung einer PVD-Ta(N) Metallschicht ist allgemein besser als bei Schichtsystemen, die mit CVD-Verfahren hergestellt wurden, da z.B. unerwünschte chemische Prozesse an den Grenzflächen beim PVD-Abscheideprozess entfallen und die kinetische Energie der gesputterten Teilchen beim Auftreffen höher ist.

Die hierbei erzeugte Grenzschicht entspricht der umliegenden Barriere und lässt eine vergleichbar gute Elektromigrationsbeständigkeit erwarten. Unter der Cu-Metallisierung 3 befindet sich noch eine optionale SiN-Schicht 6 als Diffusionsbarriere und Ätzstopschicht.

In Frage kommt für die weitere Metallschicht 5 die Abscheidung von z.B. PVD Ta, PVD Ta(N), PVD Ta(N)/Ta, PVD Ta/Ta(N) oder anderer Materialien und -kombinationen, wie Ti, Al, Ti/Al, Zr, Hf, Nb, Ru, Rh, Ir. Da diese weitere Metallschicht 5 als metallische Deckschicht jedoch sämtliche Leitbahnen in dieser Ebene kurz schließen würde, wird diese Schicht komplett in eine nicht leitende Schicht aus einem Metalloxid 7, wie z.B. Tantalpentoxid umgewandelt. Das kann z.B. einfach durch eine thermische Oxidation erfolgen, was in einem backendverträglichen Temperaturbereich zwischen 20 und 500 °C erfolgen kann.

Die vorstehend genannten Materialien werden dabei zu einem entsprechenden Metalloxid, also einem Dielektrikum, wie zum Beispiel Ta₂O₅, Al₂O₃, HfO₂, Nb₂O₅, RuO₂, Rh₂O₃, Ir₂O₃ usw., umgewandelt. (Fig. 2)

Wenn allerdings zwischen zwei Durchkontaktierungen 4 z.B. ein Ta(N)-Widerstand 8 (TFR-Widerstand) hergestellt werden soll, wird der entsprechende Bereich der weiteren Metallschicht 5 vor der Oxidation mit SiO₂ abgedeckt (Fig. 3).

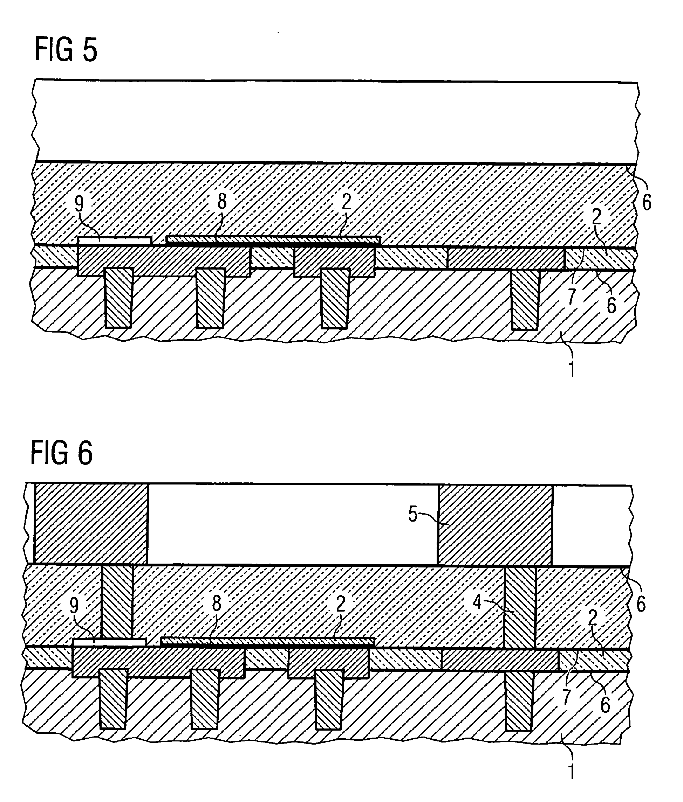

Eine weitere Möglichkeit ist die Nutzung und Integration von anodisch/thermisch oxidiertem Ta/N für MIM Kondensatoren 9 (MIM = Metall. Isolator, Metall). Um das zu erreichen, wird das großflächig abgeschiedene Ta(N) in dem Bereich, wo der MIM-Kondensator entstehen soll, nicht geschützt, so dass dieser Bereich zu Ta₂O₅ oxidiert wird und als Dielektrikum für den MIM-Kondensator dient(Fig. 4, 5).

Fig. 6 zeigt ein mit Tantalpentoxid passiviertes Cu-Level mit einem Ta(N)-Widerstand 8 und einem MIM-Kondensator 9 mit Ta₂0₅ als Dielektrikum.

Die Erfindung ermöglicht die Herstellung eines wesentlich verbesserten Barriere-Interfaces für metallische Leitbahnsysteme durch eine metallische Beschichtung, die im Folgeprozess im Wesentlichen komplett oxidiert wird, so dass ein nicht leitendes Metalloxid entsteht.

Die grundlegende Idee der Erfindung besteht darin, eine aufgebrachte Metallschicht (weitere Metallschicht 5) in ein Dielektrikum (Metalloxid 7) umzuwandeln und die so erzeugte Dielektrikumsschicht für verschiedene Anwendungen (Passivierung, Stopschicht, MIM-Dielektrikum usw. zu verwenden.

Als MIM-Dielektrikum können auch Al₂O₃, HfO₂, Nb₂O₅ usw. verwendet werden.

### Bezugzeichenliste

- 1: Substrat
- 2: SiO2
- 3: Cu-Metallisierung / Metallleitbahn
- 4: Durchkontaktierung
- 5: weitere Metallschicht
- 6: Si-N-Schicht
- 7: Metalloxid
- 8: Ta(N)-Widerstand
- 9: MIM-Kondensator

## Patentansprüche

1. Verfahren zur Herstellung einer multifunktionellen Dielektrikumsschicht auf frei liegenden metallischen Leitbahnsystemen auf einem Substrat, wobei auf den frei liegenden Metallleitbahnen (3) ganzflächig eine weitere Metallschicht (5) abgeschieden wird, die anschließend teilweise in ein nichtleitendes Metalloxid (7), die Dielektrikumsschicht, umgewandelt wird und wobei Teile der weiteren Metallschicht vor der Oxidation zur Bildung eines Metall-Dünnfilmwiderstandes abgedeckt werden, **dadurch gekennzeichnet, dass** die Dielektrikumsschicht auf einigen Metallleitbahnen als Passivierungsschicht und auf anderen Metallleitbahnen als MIM-Dielektrikum zur Integration eines MIM-Kondensators ausgebildet ist.

2. Verfahren nach Anspruch 1, **dadurch gekennzeichnet, dass** die Metallleitbahnen (3) in einem Isolator auf einem Substrat (1) eingebettet und an den Seitenwänden mit einer Diffusionsbarriere versehen worden sind und dass die weitere Metallschicht (5) nach dem chemischmechanischen Polieren (CMP) auf die frei liegenden Metallleitbahnen (3) aufgetragen wird.

3. Verfahren nach Anspruch 1 und 2, **dadurch gekennzeichnet, dass** die Metallleitbahnen (3) aus Kupfer, Aluminium, Wolfram, Gold oder anderen leitfähigen Materialien bestehen.

4. Verfahren nach Anspruch 1, **dadurch gekennzeichnet, dass** auf den Metallleitbahnen (3), die eine subtraktive Architektur aufweisen, indem eine auf einem Isolator auf dem Substrat (1) ganzflächig abgeschiedene Metallschicht nachträglich strukturiert worden ist, die weitere Metallschicht (5) abgeschieden wird.

5. Verfahren nach Anspruch 4, **dadurch gekennzeichnet, dass** die Metallleitbahnen (3) aus Aluminium, Kupfer, Wolfram, Siliziden, Nitriden oder anderen leitfähigen Materialien bestehen.

6. Verfahren nach Anspruch 1, **dadurch gekennzeichnet, dass** auf Metallleitbahnen (3), die durch Pattern Plating auf einem Isolator auf dem Substrat hergestellt worden sind, die weitere Metallschicht (5) aufgetragen wird.

7. Verfahren nach einem der Ansprüche 1 bis 6, **dadurch gekennzeichnet, dass** die Umwandlung der weiteren Metallschicht (5) in ein nichtleitendes Metalloxid (7) durch eine thermische und/oder anodische und/oder plasmachemische Oxidation erfolgt.

8. Verfahren nach Anspruch 7, **dadurch gekennzeichnet, dass** die Oxidation in einem backendverträglichen Temperaturbereich zwischen 20 - 500 °C erfolgt.

9. Verfahren nach einem der Ansprüche 1 bis 8, **dadurch gekennzeichnet, dass** die weitere Metallschicht (5) durch einen PVD-Abscheideprozess hergestellt wird.

10. Verfahren nach Anspruch 9, **dadurch gekennzeichnet, dass** Tantal abgeschieden wird.

11. Verfahren nach Anspruch 9, **dadurch gekennzeichnet, dass** Ta(N) abgeschieden wird.

12. Verfahren nach Anspruche 10 oder 11, **dadurch gekennzeichnet, dass** alternativ zu Ta oder Ta(N) weitere Materialien/Materialkombinationen wie Ti, Al, Zr, Hf , Nb, Ru, Rh, Ir abgeschieden werden.

13. Verfahren nach einem der Ansprüche 1 bis 12, **dadurch gekennzeichnet, dass** die Abdeckung von Teilen der weiteren Metallschicht mit einer SiO₂- oder Si₃N₄-Schicht erfolgt.

## Claims

1. Process for producing a multifunctional dielectric layer on uncovered metallic interconnect systems on a substrate, wherein a further metal layer (5) is deposited over the entire surface of the uncovered metal interconnects (3), and this further metal layer is then partially converted into a nonconducting metal oxide (7), the dielectric layer, and wherein parts of the further metal layer are covered prior to the oxidation in order to form a metal thin film resistor, **characterized in that** the dielectric layer is formed as a passivation layer on some metal interconnects and as an MIM dielectric for the integration of an MIM capacitor on other metal interconnects.

2. Process according to Claim 1, **characterized in that** the metal interconnects (3) have been embedded in an insulator on a substrate (1) and have been provided with a diffusion barrier at the side walls, and **in that** the further metal layer (5) is applied to the uncovered metal interconnects (3) after the chemical mechanical polishing (CMP).

3. Process according to Claim 1 and 2, **characterized in that** the metal interconnects (3) consist of copper, aluminium, tungsten, gold or other conductive materials.

4. Process according to Claim 1, **characterized in that** the further metal layer (5) is deposited on the metal interconnects (3), which have a subtractive architecture, by virtue of a metal layer which has been deposited over the entire surface of an insulator on the substrate (1) having subsequently been patterned.

5. Process according to Claim 4, **characterized in that** the metal interconnects (3) consist of aluminium, copper, tungsten, silicides, nitrides or other conductive materials.

6. Process according to Claim 1, **characterized in that** the further metal layer (5) is applied to metal interconnects (3) which have been produced by pattern plating on an insulator on the substrate.

7. Process according to one of Claims 1 to 6, **characterized in that** the conversion of the further metal layer (5) into a nonconducting metal oxide (7) is carried out by a thermal and/or anodic and/or plasma-chemical oxidation.

8. Process according to Claim 7, **characterized in that** the oxidation takes place in a back-end-compatible temperature range between 20 - 500°C.

9. Process according to one of Claims 1 to 8, **characterized in that** the further metal layer (5) is produced by a PVD process.

10. Process according to Claim 9, **characterized in that** tantalum is deposited.

11. Process according to Claim 9, **characterized in that** Ta(N) is deposited.

12. Process according to Claims 10 or 11, **characterized in that** further materials/material combinations, such as Ti, Al, Zr, Hf, Nb, Ru, Rh, Ir, are deposited as an alternative to Ta or Ta(N).

13. Process according to one of Claims 1 to 12, **characterized in that** parts of the further metal layer are covered with an SiO₂ or Si₃N₄ layer.

## Revendications

1. Procédé pour réaliser une couche diélectrique multifonctionnelle sur des systèmes de pistes conductrices en métal mises à nu sur un substrat, dans lequel une autre couche métallique (5) est déposée sur toute la surface des pistes conductrices (3) en métal mises à nu et est ensuite convertie partiellement en un oxyde métallique non conducteur (7), à savoir la couche diélectrique, des parties de l'autre couche métallique étant recouvertes avant l'oxydation pour former une résistance en film métallique mince, **caractérisé en ce que** la couche diélectrique est formée sur certaines pistes conductrices en métal comme couche de passivation et sur d'autres couches conductrices en métal comme diélectrique MIM pour l'intégration d'un condensateur MIM.

2. Procédé selon la revendication 1, **caractérisé en ce que** les pistes conductrices (3) en métal sont incorporées dans un isolant sur un substrat (1) et sont dotées d'une barrière à la diffusion sur leurs parois latérales et **en ce que** l'autre couche métallique (5) est appliquée sur les pistes conductrices (3) en métal mises à nu après polissage chimique-mécanique (CMP).

3. Procédé selon les revendications 1 et 2, **caractérisé en ce que** les pistes conductrices (3) en métal sont constituées de cuivre, d'aluminium, de tungstène, d'or ou d'autres matériaux conducteurs.

4. Procédé selon la revendication 1, **caractérisé en ce que**, sur les pistes conductrices (3) en métal qui présentent une architecture soustractive par le fait qu'une couche métallique déposée sur toute la surface d'un isolant présent sur le substrat (1) est ultérieurement structurée, l'autre couche métallique (5) est déposée.

5. Procédé selon la revendication 4, **caractérisé en ce que** les pistes conductrices (3) en métal sont constituées d'aluminium, de cuivre, de tungstène, de siliciures, de nitrures ou d'autres matériaux conducteurs.

6. Procédé selon la revendication 1, **caractérisé en ce que** l'autre piste métallique (5) est appliquée sur les pistes conductrices (3) en métal qui ont été réalisées par plaquage suivant un motif sur un isolant disposé sur le substrat.

7. Procédé selon l'une des revendications 1 à 6, **caractérisé en ce que** la conversion de l'autre couche métallique (5) en un oxyde métallique non conducteur (7) s'effectue par oxydation thermique et/ou anodique et/ou chimique au plasma.

8. Procédé selon la revendication 7, **caractérisé en ce que** l'oxydation a lieu dans une plage de température compatible avec l'arrière-plan et comprise entre 20 et 500° C.

9. Procédé selon l'une des revendications 1 à 8, **caractérisé en ce que** l'autre couche métallique (5) est réalisée par une opération de dépôt par PVD.

10. Procédé selon la revendication 9, **caractérisé en ce que** l'on dépose du tantale.

11. Procédé selon la revendication 9, **caractérisé en ce que** l'on dépose du Ta(N).

12. Procédé selon les revendications 10 ou 11, **caractérisé en ce qu'**en variante au Ta ou au Ta(N), on dépose d'autres matériaux ou combinaisons de matériaux, par exemple Ti, Al, Zr, Hf, Nb, Ru, Rh ou Ir.

13. Procédé selon l'une des revendications 1 à 12, **caractérisé en ce que** le recouvrement de parties de l'autre couche métallique s'effectue par une couche de SiO₂ ou de Si₃N₄.
